# EUROPEAN PATENT APPLICATION

(11) **EP 4 394 091 A1**
(43) Date of publication of application: **03.07.2024**
(21) Application number: 23220141.8
(22) Date of filing: 22.12.2023
(51) Int. Cl.: C30B 25/02, C23C 16/32, C30B 29/36, H01L 21/02

(54) **SEMICONDUCTOR HEAT TREATMENT MEMBER**

(30) Priority: 27.12.2022 JP 2022209503; 16.11.2023 JP 2023195058
(71) Applicant: Coorstek KK, Tokyo 141-0032 (JP)
(72) Inventor: Inoue, Masatoshi, Nishiokitamagun, Yamagata, 999-1351 (JP); Suzuki, Kenji, Nishiokitamagun, Yamagata, 999-1351 (JP)
(74) Representative: Grünecker Patent- und Rechtsanwälte PartG mbB

(57) **Abstract**

A semiconductor heat treatment member includes: a base material; and a SiC film on a surface of the base material, in which the SiC film contains a crystal containing 3C-SiC having peaks at (111), (311), (200), (220) and (222) and 2H-SiC having peaks at (101) and (103), and includes, in order from a side of the base material, at least a first SiC layer and a second SiC layer, which have different peak intensities in X-ray diffraction of the crystal.

## Description

### TECHNICAL FIELD

The present invention relates to a semiconductor heat treatment member such as a susceptor that supports a wafer in an epitaxial film forming apparatus, and a method for producing the same.

### BACKGROUND ART

As a pretreatment for forming a semiconductor circuit on a silicon (Si) wafer or a silicon carbide (SiC) wafer, there is a step of forming an epitaxial film on the wafer. In the case of forming an epitaxial film on a wafer, those obtained by coating a carbon base material with SiC or tantalum carbide (TaC) by chemical vapor deposition (CVD) are used for a susceptor (semiconductor heat treatment member) that supports the wafer.

Qualities required of a SiC film susceptor or a TaC film susceptor include that the heat-treated wafer can maintain a quality thereof, and that the susceptor can complete a specified life thereof. In addition, improving corrosion resistance of the susceptor is one of top priorities for preparing a high-quality epitaxial wafer, improving a wafer yield, and reducing a cost.

Generally, growth of the epitaxial film is performed at 1250°C or lower for the Si wafer and 1400°C or higher for the SiC wafer. When an epitaxial film is grown on the Si wafer or the SiC wafer, polysilicon is deposited on the susceptor. This polysilicon needs to be removed (cleaned) periodically by a high-temperature treatment with a reducing gas such as hydrogen chloride (HCl), and a dimensional change or particle generation caused by polysilicon deposition on the susceptor is reset.

However, when the polysilicon deposited on the SiC film susceptor is removed (cleaned) by a high-temperature treatment with a reducing gas such as hydrogen chloride, a SiC film is also corroded. On the other hand, when removal (cleaning) is not performed, resistance abnormalities or defects may occur in the heat-treated wafer due to impurities such as nitrogen or boron contained in the SiC film. Since such resistance abnormalities or defects occur immediately after the susceptor is used, the susceptor needs to be replaced, which is a problem in terms of cost.

During pre-shipment inspection for the susceptor, metal impurities are generally analyzed using inductively coupled plasma mass spectrometry (ICP-MS), and analysis on a nitrogen or boron concentration, which needs to be performed using secondary ion mass spectrometry (SIMS), is not performed. If analysis on nitrogen or boron is added to the pre-shipment inspection, initial defects are coped with, but an analysis cost is increased, leading to a higher price of semiconductor products. On the other hand, when a susceptor coated with TaC rather than SiC is used, problems caused by impurities are alleviated, but the TaC film susceptor is more expensive than the SiC film susceptor.

In order to solve the above problems, Patent Literature 1 discloses a susceptor for vapor phase growth in which a surface of a graphite base material is coated a SiC film using a CVD method, in which an interface between the graphite base material and the SiC film and a surface of the SiC film are subjected to a purification treatment. With the purification treatment, impurities and particles on the outermost surface of the SiC film, which were sometimes found in the conventional susceptors, are reliably removed. As a result, resistance abnormalities or non-doping defects in a Si wafer, which often occur due to the presence of impurities, are avoided, and epitaxial film growth efficiency is remarkably improved. In addition, by removing the amount of impurities, the possibility of pinholes occurring in the SiC film can be extremely reduced.

As a susceptor having reduced nitrogen and boron concentrations, a semiconductor heat treatment member having excellent adhesion and retention properties of CVD deposits such as a Si₃N₄ deposit film has been reported (Patent Literature 2). According to Patent Literature 2, in X-ray photoelectron spectroscopy analysis on a semiconductor treatment member with a SiC film formed on a surface of a substrate or consisting only of SiC, an amount of a fluorine element is 0.3 atomic% or less, an amount of organic nitrogen is 0.7 atomic% or less, an amount of a hydrocarbon component is 29 atomic% or less, and an amount of organic CO is 4 atomic% or less, and at this time, the CVD deposits have excellent adhesion and retention properties and are less likely to cause particle contamination problems in a semiconductor treatment apparatus such as a low pressure CVD (LPCVD) apparatus.

In a step of growing an epitaxial film on a wafer, properties such as high-temperature resistance and crack resistance against rapid temperature lowering from a high temperature are required in addition to corrosion resistance against a cleaning gas. The susceptor has a carbon base material and a SiC film made of different materials. In addition, the SiC film is often formed by multiple times of coating. Therefore, when cracks occur in the SiC film, impurities contained in the carbon base material diffuse, influencing a quality or a yield of the wafer. When cracks occur in the susceptor, the susceptor needs to be replaced immediately. Then, a frequency of replacing the susceptor increases, which may be a factor in increasing the price of semiconductor products.

### CITATION LIST

### PATENT LITERATURE

Patent Literature 1: JPH11-157989A
Patent Literature 2:JP3956291B

### SUMMARY OF INVENTION

Therefore, an object of the present invention is to provide a semiconductor heat treatment member which has crack resistance, which allows a Si wafer or a SiC wafer to maintain a quality thereof, and which has a long service life.

A semiconductor heat treatment member according to the present invention includes: a base material; and a SiC film on a surface of the base material, in which the SiC film contains a crystal containing 3C-SiC having peaks at (111), (311), (200), (220), and (222) and 2H-SiC having peaks at (101) and (103), and includes, in order from a side of the base material, at least a first SiC layer and a second SiC layer, which have different peak intensities in X-ray diffraction of the crystal.

With such a configuration, crack resistance can be provided.

In the SiC film, it is preferable that a nitrogen concentration is 0.05 ppm or less, and a boron concentration is 0.02 ppm or less.

It is preferable that, in the first SiC layer, a ratio of a peak intensity at the (101) plane of the 2H-SiC to a peak intensity at the (111) plane of the 3C-SiC is 0.000 or more and 0.020 or less, and a ratio of a peak intensity at the (103) plane of the 2H-SiC to the peak intensity at the (111) plane of the 3C-SiC is 0.000 or more and 0.020 or less.

It is preferable that, in the second SiC layer, a ratio of a peak intensity at the (101) plane of the 2H-SiC to a peak intensity at the (111) plane of the 3C-SiC is 0.030 or more and 0.100 or less, and a ratio of a peak intensity at the (103) plane of the 2H-SiC to the peak intensity at the (111) plane of the 3C-SiC is 0.020 or more and 0.050 or less.

In the semiconductor heat treatment member according to the present invention, the SiC film contains two crystals, i.e., 3C-SiC and 2H-SiC, and includes two layers, i.e., a low temperature layer and high temperature layer. With such a crystal layer structure, the semiconductor heat treatment member can be provided with crack resistance.

In addition to the above effects, since the semiconductor heat treatment member obtained by a production method according to the present invention has sufficiently reduced nitrogen and boron concentrations in the SiC film, it is possible to prevent resistance abnormalities or defects from occurring in a Si wafer or a SiC wafer after a heat treatment.

### BRIEF DESCRIPTION OF DRAWINGS

Fig. 1 is a cross-sectional view of a susceptor according to the present invention.
Fig. 2 is an enlarged cross-sectional view of a portion of the susceptor shown in Fig. 1.
Fig. 3 is a cross-sectional view schematically showing a CVD apparatus used in producing the susceptor in Fig. 1.
Fig. 4 is a SEM image of a cross section of a SiC film (low temperature layer and high temperature layer) of the susceptor according to the present invention.
Fig. 5 shows a peak intensity ratio by X-ray diffraction for the SiC film in Fig. 4.

### DESCRIPTION OF EMBODIMENTS

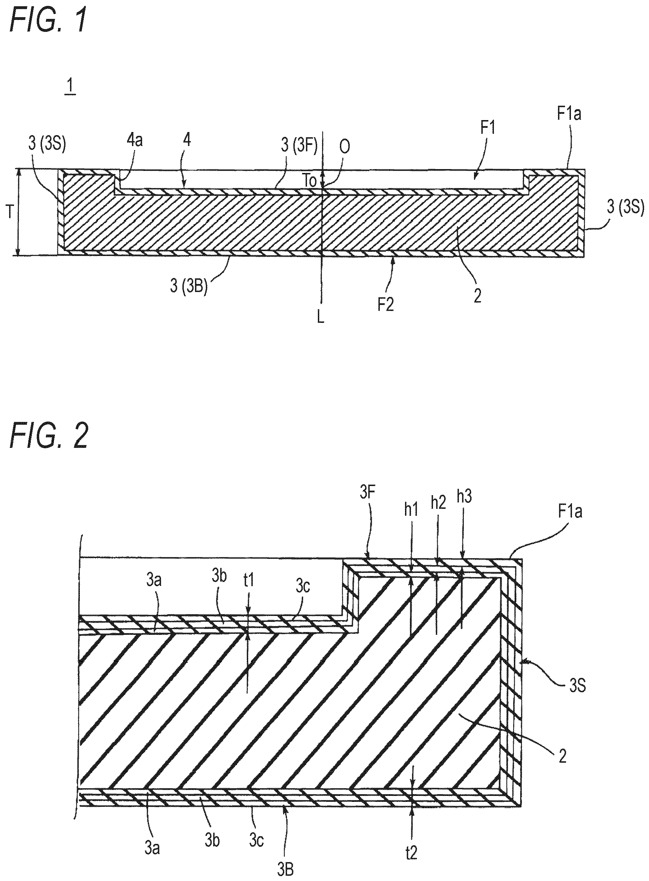

Hereinafter, a semiconductor heat treatment member according to one embodiment of the present invention will be described with reference to Fig. 1 to Fig. 3. The drawings are schematic or conceptual, and the relationship between the thickness and width of each part, the size ratio between parts, etc. are not accurately illustrated.

The semiconductor heat treatment member is a ceramic member that supports a semiconductor material such as a Si wafer or a SiC wafer inside a semiconductor production apparatus. A size of the Si wafer or the SiC wafer may be 4 inches, 5 inches, 6 inches, 8 inches or 12 inches.

Abase materials used for the semiconductor heat treatment member is silicon, carbon such as graphite, and silicon carbide. Among these, the carbon base material is low in cost, has low processing difficulty, and has a short lead time. In the case of a silicon substrate, a carbonized layer made of a hydrocarbon gas such as methane, ethane, propane, ethylene, and acetylene may be formed on a surface of the substrate, and then a SiC film, which will be described later, may be formed.

In the present embodiment, a susceptor including carbon as a base material and a SiC film on a surface of the base material will be described as a semiconductor heat treatment member used to grow an epitaxial film on a surface of a Si wafer.

As shown in Fig. 1, a susceptor 1 (semiconductor heat treatment member) includes a disc-shaped carbon base material 2. A size of the carbon base material 2 is preferably 1.0 mm to 20.0 mm in thickness and 50 mm to 400 mm in diameter, and a content of metal elements (iron, nickel, chromium, etc.) is preferably 0.05 ppm or less.

The susceptor 1 is a so-called single-wafer type susceptor in which one concave counterbore portion 4 on which a semiconductor substrate is to be placed is formed in one main surface F1.

The counterbore portion 4 is formed into a circular shape in a plan view, and a columnar recess portion 4a is formed in the center. In addition, the susceptor 1 has circular symmetry with a center portion O being a rotation axis L. At this time, when a depth of a deepest portion (center portion O) in the counterbore portion 4 is defined as To, an average depth Td (not shown) is To/2.

It is preferable that a ratio (T/Td) of a thickness T of the susceptor 1 to the average depth Td satisfies 6 ≤ T/Td ≤ 30. When the ratio (T/Td) of the thickness T of the susceptor 1 to the average depth Td is within the above range, a warpage prevention effect can be obtained in the counterbore portion 4. Note that it is preferable that a ratio (T/To) of the thickness T of the susceptor 1 to the depth To satisfies 3 ≤ T/To ≤ 13.

A carbon material is used as the carbon base material 2, and silicon carbide is used as a thin film 3. The entire surface of the carbon base material 2 is coated with the thin film 3 made of silicon carbide (SiC) and having a predetermined thickness (for example, 60 µm or more). The thin film 3 has a role of protecting the carbon base material 2, preventing dust generation from the carbon base material 2 and outward diffusion of impurities, and preventing warpage of the carbon base material 2.

Thus, the thin film 3 includes a thin film 3F made of silicon carbide and for coating the main surface F1 as a wafer support surface of the susceptor 1, a thin film 3B made of silicon carbide and for coating the other main surface F2 as a back surface facing the main surface F1, and a thin film 3S made of silicon carbide and for coating an outer peripheral surface of carbon base material 2.

Here, a ratio of an average film thickness t2 of the thin film 3B formed on the other main surface F2 to an average film thickness t1 of the thin film 3F formed on the main surface F1 in the susceptor 1 shown in Fig. 2 is preferably between 0.7 and 1.3. When the above ratio is 0.7 to 1.3, a uniform epitaxial film can be obtained without a difference in thermal conductivity caused by a variation in film thickness.

The SiC film formed on the surface of the carbon base material 2 is a crystal containing 3C-SiC and 2H-SiC, and the crystal includes, in order from a carbon base material 2 side, at least a first SiC layer and a second SiC layer, which have different peak intensities in X-ray diffraction. Note that, in a method for producing a semiconductor heat treatment member to be described later, since before starting keep coating, the first SiC layer is formed by introducing a raw material gas at a temperature lower than a temperature during keep coating, and the second SiC layer is formed by keep coating at a higher temperature, the first SiC layer is also referred to as a low temperature layer and the second SiC layer is also referred to as a high temperature layer in the present description.

The surface of the carbon base material 2 contains a polymorphic crystal containing 3C-SiC and 2H-SiC as a CVD-SiC film obtained by crystal growth by a normal pressure CVD method.

In this regard, SiC has many polymorphisms due to a difference in stacking order. Typical polymorphs include 3C-SiC, 2H-SiC, and 4H-SiC. The 3C-SiC is a cubic crystal, and the 2H-SiC and the 4H-SiC are hexagonal crystals.

Among crystals of SiC, the 3C-SiC cubic crystal has the smallest band gap among the polymorphs. The 3C-SiC cubic crystal is a stable and high-quality crystal formed at a low temperature, and is thus easy to be used in device design, and even when an area is increased, an increase in cost can be prevented.

The 3C-SiC cubic crystal has peaks corresponding to (111), (311), (200), (220), and (222) by X-ray diffraction. Having such peaks means that a good crystal is formed by epitaxial growth of SiC.

The 2H-SiC hexagonal crystal has the largest band gap among the polymorphs. The 2H-SiC has peaks corresponding to (101) and (103) by X-ray diffraction.

It is preferable that, in the first SiC layer (low temperature layer), a ratio of a peak intensity at the (101) plane of the 2H-SiC to a peak intensity at the (111) plane of the 3C-SiC is 0.000 or more and 0.020 or less, and a ratio of a peak intensity at the (103) plane of the 2H-SiC to the peak intensity at the (111) plane of the 3C-SiC is 0.000 or more and 0.020 or less.

It is preferable that, in the second SiC layer (high temperature layer), a ratio of a peak intensity at the (101) plane of the 2H-SiC to a peak intensity at the (111) plane of the 3C-SiC is 0.030 or more and 0.100 or less, and a ratio of a peak intensity at the (103) plane of the 2H-SiC to the peak intensity at the (111) plane of the 3C-SiC is 0.020 or more and 0.050 or less.

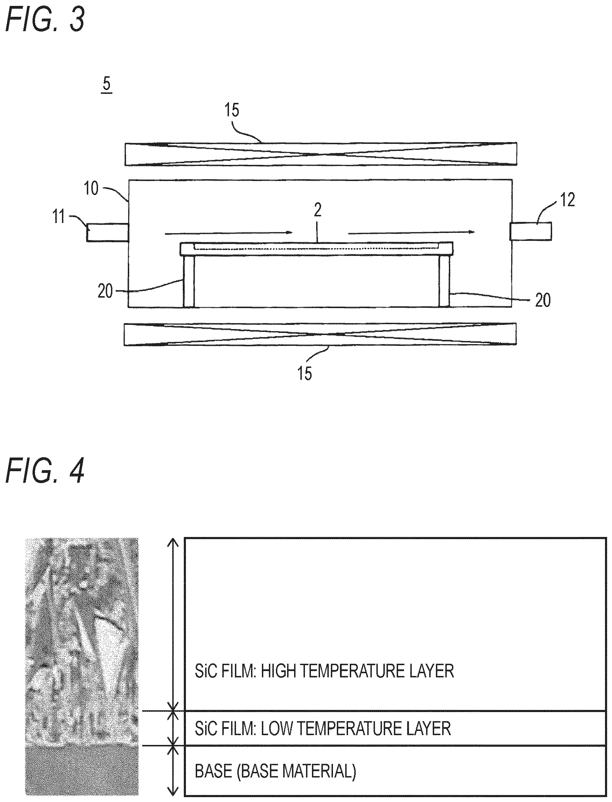

Fig. 4 is an image obtained by observing cross-sectional structures of the first SiC layer (low temperature layer) and the second SiC layer (high temperature layer) formed on the base material using a scanning electron microscope (SEM).

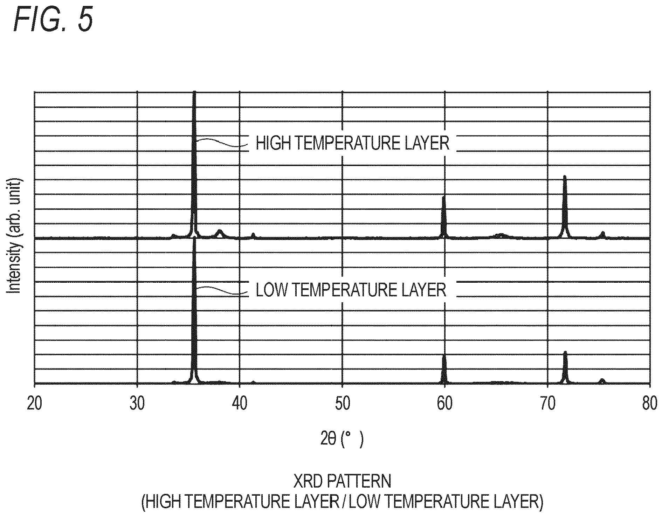

Fig. 5 is a diffraction chart showing a peak intensity ratio of the first SiC layer (low temperature layer) and the second SiC layer (high temperature layer) by the X-ray diffraction. It can be seen that peaks and vertices thereof in the low temperature layer coincide those in the high temperature layer, and the SiC film in the susceptor 1 has high crystallinity.

Note that, in both the first SiC layer (low temperature layer) and the second SiC layer (high temperature layer), the 3C-SiC crystal has peaks at (111), (311), (200), (220), and (222) in the X-ray diffraction, and the 2H-SiC crystal has peaks at (101) and (103) in the X-ray diffraction.

The X-ray diffraction is diffraction using X-rays (CuKα rays) of 40 keV.

The first SiC layer (low temperature layer) has a thickness of preferably 1 µm to 10 µm, and more preferably 1 µm to 3 µm.

The second SiC layer (high temperature layer) has a thickness of preferably 3 µm to 500 µm, and more preferably 5 µm to 300 µm.

In the susceptor 1, the CVD-SiC film contains two crystals, i.e., 3C-SiC and 2H-SiC, and includes two layers, i.e., a low temperature layer and high temperature layer. With such a crystal layer structure, the CVD-SiC film has crack resistance.

In the SiC film, it is preferable that a nitrogen concentration is 0.05 ppm or less, and a boron concentration is 0.02 ppm or less. When the nitrogen or boron concentration in the SiC film of the susceptor 1 is reduced, it is possible to prevent resistance abnormalities or defects from occurring in the Si wafer or the SiC wafer.

A method for producing the above semiconductor heat treatment member including the SiC film on the surface of the base material includes a step of introducing a raw material gas at a temperature lower than the keep coating temperature before starting keep coating in a step of forming the above SiC film. With such a step, the SiC film of the semiconductor heat treatment member contains two crystals, i.e., 3C-SiC and 2H-SiC, and includes two layers, i.e., a low temperature layer and high temperature layer, and therefore, the crack resistance is provided. In addition, since the nitrogen and boron concentrations in the SiC film are sufficiently reduced, it is possible to prevent resistance abnormalities or defects from occurring in the Si wafer or the SiC wafer after a heat treatment.

A method for producing the susceptor 1 will be described. Thus, a method of forming a SiC film having a low nitrogen concentration and a low boron concentration by CVD on a surface of a carbon base material processed into a product shape includes a step of introducing a raw material gas at a temperature lower than the keep coating temperature before starting keep coating. The temperature is preferably 50°C to 100°C lower than the keep coating temperature.

The above susceptor 1 can be produced, for example, by using a CVD apparatus 5 as shown in Fig. 3.

The CVD apparatus 5 shown in Fig. 3 includes a chamber 10 for forming a treatment space, a gas inlet 11 provided on a side surface of the chamber 10 to supply a carrier gas (hydrogen gas) into the chamber 10, and a gas outlet 12 provided on a side surface of the chamber 10 opposite to the inlet 11. In addition, a support portion 20 for supporting a lower surface side of the carbon base material 2 of the susceptor 1 within the chamber 10 is provided. Further, heater units 15 are provided above and below the chamber 10, and are configured to be able to raise a temperature inside the chamber to a predetermined temperature.

In the case of producing the susceptor 1 using this CVD apparatus 5, the carbon base material 2 for a Si wafer or a SiC wafer made of a carbon material in which a circular counterbore portion has been formed in advance is disposed on the support portion 20 inside the chamber 10.

H₂ is used as a carrier gas (diluent gas) and raw material gases (SiCl₄, CsHs) are used, followed by gradual introduction, and then keep coating is performed for 60 to 120 minutes at a temperature of 1000°C to 1300°C under a chamber pressure of 1500 Pa to 4500 Pa. During the keep coating, a treatment is performed at SiCl₄:C₃H₈:H₂ = 15 to 20:3 to 6:150 to 200 (L/min), whereby a susceptor 1 with a SiC film containing a mixture of 3C-SiC and 2H-SiC and having excellent crystallinity is obtained. Note that the temperature is raised by introducing only H₂, and at this time, a vacuum pump capable of maintaining a degree of vacuum to 1 Torr or less is used.

Immediately before starting the keep coating, a raw material gas is introduced over 20 to 30 minutes while the temperature is raised before reaching a predetermined temperature (temperature during the keep coating). The temperature inside the CVD apparatus 5 when the raw material gas is introduced is lower than the temperature during the keep coating. In addition, a H₂ atmosphere is maintained before and after the introduction. Accordingly, the first SiC layer (low temperature layer) having a thickness of 1 µm to 10 µm is formed between the carbon base material 2 and the second SiC layer (high temperature layer) having a thickness of 3 µm to 500 µm formed thereon.

After the keep coating, only H₂ is introduced to lower the temperature. After lowering the temperature by 100°C over 30 to 120 minutes under a chamber pressure of 3500 Pa to 10000 Pa, the introduction of H₂ is stopped, and the temperature is continued to be lowered for 90 minutes or longer at a degree of vacuum of 1 Torr or less. When the temperature is lowered to 800°C or lower, the H₂ gas is introduced again, and the temperature is continued to be lowered.

With this process, it is possible to obtain a semiconductor heat treatment member such as a susceptor having crack resistance and coated with a low nitrogen and low boron concentration CVD-SiC film in which the nitrogen concentration is 0.05 ppm or less and the boron concentration is 0.02 ppm or less in the SiC film.

Note that in the above embodiment, a susceptor has been described as an example of the semiconductor heat treatment member according to the present invention. However, the present invention is not limited to this form, and can be widely applied to a semiconductor heat treatment member in which the SiC film is formed on the surface of the carbon base material.

### Examples

Hereinafter, the present invention will be specifically described based on Examples, but the present invention is not limited to the Examples shown below.

### [Example 1]

A purification treatment was performed on isotropic high-purity graphite (manufactured by CoorsTek KK) to reduce an impurity concentration (metal elements such as Fe, Ni, or Cr) in a carbon base material to 0.05 ppm or less, to obtain a base material.

A SiC film was formed on the above carbon base material by using the CVD apparatus shown in Fig. 3. In the above CVD apparatus, the above carbon base material was placed in the chamber, and after the temperature was lowered to 1 Torr or less using a vacuum pump, a carrier gas (H₂) was introduced.

Next, the temperature inside the chamber was increased to 1200°C. When the temperature inside the chamber was raised from 1200°C to 1300°C, raw material gases (SiCl₄ and C₃H₈) and the carrier gas were introduced over 25 minutes. Thereafter, keep coating was performed at 1300°C and 2000 Pa for 11 hours.

After the keep coating, only H₂ was introduced to lower the temperature. After lowering the temperature by 100°C over 120 minutes under a chamber pressure of 5000 Pa, the introduction of H₂ was stopped, and the temperature was continued to be lowered for 90 minutes or longer at a degree of vacuum of 1 Torr or less. When the temperature was lowered to 800°C or lower, the H₂ gas was introduced again, and the temperature was continued to be lowered.

With the above procedure, the carbon base material was coated with a CVD-SiC film. In the obtained carbon base material with a SiC film, the nitrogen and boron concentrations in the SiC film were measured using secondary ion mass spectrometry (SIMS). The nitrogen concentration was 0.041 ppm, and the boron concentration was 0.001 ppm.

A cross section of the carbon base material with a SiC film was observed using a scanning electron microscope (SEM). In addition, the carbon base material with a SiC film was observed using powder X-ray diffraction (XRD). In the SiC film on the carbon base material, a sharp diffraction profile was observed in both a first SiC layer on the base material side and a second SiC layer formed on the first SiC layer. The results are shown in Fig. 4 and Fig. 5.

The peak intensity ratio is as shown in Table 1.

**[Table 1]**

| | First SiC layer | Second SiC layer |
|---|---|---|
| 2H-SiC (101)/3C-SiC (111) | 0.011 | 0.050 |
| 2H-SiC (103)/3C-SiC (111) | 0.012 | 0.025 |

### [Example 2]

A purification treatment was performed on isotropic high-purity graphite (manufactured by CoorsTek KK) to reduce an impurity concentration (metal elements such as Fe, Ni, or Cr) in a carbon base material to 0.05 ppm or less, to obtain a base material.

A SiC film was formed on the above carbon base material by a CVD method. In the above CVD apparatus, the above carbon base material was placed in the chamber, and after the temperature was lowered to 1 Torr or less using a vacuum pump, a carrier gas (H₂) was introduced.

Next, the temperature inside the chamber was increased to 1240°C. When the temperature inside the chamber was raised from 1240°C to 1250°C, raw material gases (SiCl₄ and C₃H₈) and the carrier gas were introduced over 25 minutes. Thereafter, keep coating was performed at 1250°C and 2000 Pa for 11 hours.

After the keep coating, only Hz was introduced to lower the temperature. After lowering the temperature by 100°C over 120 minutes under a chamber pressure of 5000 Pa, the introduction of H₂ was stopped, and the temperature was continued to be lowered for 90 minutes or longer at a degree of vacuum of 1 Torr or less. When the temperature was lowered to 800°C or lower, the H₂ gas was introduced again, and the temperature was continued to be lowered.

With the above procedure, the carbon base material was coated with a CVD-SiC film. In the obtained carbon base material with a SiC film, the nitrogen and boron concentrations in the SiC film were measured using secondary ion mass spectrometry (SIMS). The nitrogen concentration was 0.048 ppm, and the boron concentration was 0.001 ppm.

The carbon base material with a SiC film was observed using powder X-ray diffraction (XRD). In the SiC film on the carbon base material, a sharp diffraction profile was observed in both a first SiC layer on the base material side and a second SiC layer formed on the first SiC layer. The peak intensity ratio is as shown in Table 2.

**[Table 2]**

| | First SiC layer | Second SiC layer |
|---|---|---|
| 2H-SiC (101)/3C-SiC (111) | 0.034 | 0.048 |
| 2H-SiC (103)/3C-SiC (111) | 0.025 | 0.031 |

### [Example 3]

A purification treatment was performed on isotropic high-purity graphite (manufactured by CoorsTek KK) to reduce an impurity concentration (metal elements such as Fe, Ni, or Cr) in a carbon base material to 0.05 ppm or less, to obtain a base material.

A SiC film was formed on the above carbon base material by a CVD method. In the above CVD apparatus, the above carbon base material was placed in the chamber, and after the temperature was lowered to 1 Torr or less using a vacuum pump, a carrier gas (H₂) was introduced.

Next, the temperature inside the chamber was increased to 1160°C. When the temperature inside the chamber was raised from 1160°C to 1180°C, raw material gases (SiCl₄ and C₃H₈) and the carrier gas were introduced over 25 minutes. Thereafter, keep coating was performed at 1180°C and 2000 Pa for 11 hours.

After the keep coating, only Hz was introduced to lower the temperature. After lowering the temperature by 100°C over 120 minutes under a chamber pressure of 5000 Pa, the introduction of H₂ was stopped, and the temperature was continued to be lowered for 90 minutes or longer at a degree of vacuum of 1 Torr or less. When the temperature was lowered to 800°C or lower, the H₂ gas was introduced again, and the temperature was continued to be lowered.

With the above procedure, the carbon base material was coated with a CVD-SiC film. In the obtained carbon base material with a SiC film, the nitrogen and boron concentrations in the SiC film were measured using secondary ion mass spectrometry (SIMS). The nitrogen concentration was 0.043 ppm, and the boron concentration was 0.001 ppm.

The carbon base material with a SiC film was observed using powder X-ray diffraction (XRD). In the SiC film on the carbon base material, a sharp diffraction profile was observed in both a first SiC layer on the base material side and a second SiC layer formed on the first SiC layer. The peak intensity ratio is as shown in Table 3.

**[Table 3]**

| | First SiC layer | Second SiC layer |
|---|---|---|
| 2H-SiC (101)/3C-SiC (111) | 0.011 | 0.014 |
| 2H-SiC (103)/3C-SiC (111) | 0.012 | 0.009 |

### [Example 4]

A purification treatment was performed on isotropic high-purity graphite (manufactured by CoorsTek KK) to reduce an impurity concentration (metal elements such as Fe, Ni, or Cr) in a carbon base material to 0.05 ppm or less, to obtain a base material. The base material had a thickness of 1.0 mm to 20.0 mm and was sized to be suitable for supporting a Si wafer (8 inches).

A SiC film was formed on the above carbon base material by a CVD method. In the above CVD apparatus, the above carbon base material was placed in the chamber, and after the temperature was lowered to 1 Torr or less using a vacuum pump, a carrier gas (H₂) was introduced.

Next, the temperature inside the chamber was increased to 1350°C. When the temperature inside the chamber was raised from 1350°C to 1400°C, raw material gases (SiCl₄ and C₃H₈) and the carrier gas were introduced over 25 minutes. Thereafter, keep coating was performed at 1400°C and 3000 Pa for 15 hours.

After the keep coating, only Hz was introduced to lower the temperature. After lowering the temperature by 100°C over 120 minutes under a chamber pressure of 3000 Pa, the introduction of H₂ was stopped, and the temperature was continued to be lowered for 90 minutes or longer at a degree of vacuum of 1 Torr or less. When the temperature was lowered to 800°C or lower, the H₂ gas was introduced again, and the temperature was continued to be lowered.

In the carbon base material with a SiC film obtained with the above procedure, the nitrogen and boron concentrations in the SiC film were measured using secondary ion mass spectrometry (SIMS). The nitrogen concentration was 5.87 ppm, and the boron concentration was 0.001 ppm. In the above procedure, a CVD-SiC film in which the nitrogen concentration in the SiC film was 0.05 ppm or less could not be obtained.

The carbon base material with a SiC film was observed using powder X-ray diffraction (XRD). The peak intensity ratio is as shown in Table 4.

**[Table 4]**

| | First SiC layer | Second SiC layer |
|---|---|---|
| 2H-SiC (101)/3C-SiC (111) | 0.002 | 0.030 |
| 2H-SiC (103)/3C-SiC (111) | 0.001 | 0.021 |

### [Comparative Example 1]

A SiC film was formed on the above carbon base material by a CVD method. For film formation, SiCl₄ and C₃H₈ were used as raw material gases, Hz was used as a carrier gas (diluent gas), and keep coating was performed for 11 hours at 1300°C under a chamber pressure of 4000 Pa. During temperature rise (before introduction of raw material gas), no gas was introduced, and a vacuum pump was used to maintain the degree of vacuum at 1 Torr or less.

After the keep coating, only N₂ was introduced to lower the temperature. After the temperature was controlled to be lowered to 1000°C over 120 minutes under a chamber pressure of 5000 Pa, the controlled temperature lowering was stopped, and the temperature was continued to be lowered.

A SiC layer formed on the carbon base material was one layer.

The carbon base material with a SiC film was observed using powder X-ray diffraction (XRD). The peak intensity ratio is as shown in Table 5.

**[Table 5]**

| | SiC layer |
|---|---|
| 2H-SiC (101)/3C-SiC (111) | 0.002 |
| 2H-SiC (103)/3C-SiC (111) | 0.001 |

Table 5 shows the results of thermal shock crack resistance and reducing gas resistance of the carbon base materials with a SiC film in Examples 1 to 4 and Comparative Example 1. The thermal shock crack resistance was determined by placing a sample in an apparatus, heating the sample to 1000°C (normal pressure atmosphere), then taking the sample out of the apparatus, dropping the sample into water (room temperature), and rapidly lowering the temperature (applying thermal shock) (acceleration test). This was performed for 5 cycles. Thereafter, a case where cracks were observed was defined as C. When cracks were not observed, further 5 cycles were performed, and a case where cracks were observed was defined as B, and a case where no cracks were observed was defined as A.

The reducing gas resistance was determined by placing a sample in an apparatus, setting a reduced pressure atmosphere using a vacuum pump, introducing HCl and Hz (carrier gas), performing 30 cycles (30 hr) and 50 cycles (50 hr) at a temperature of 1100°C and an exposure time of 1 hour, and then observing a surface structure of the sample using SEM.

Those having pinholes (penetrating the graphite base material) formed after 30 cycles (30 hr) were defined as C, those having no pinholes formed after 50 cycles (50 hr) were defined as A, and those having no pinholes formed after 30 cycles (30 hr) but having pinholes formed after 50 cycles (50 hr) were defined as B.

**[Table 6]**

| | Thermal shock crack resistance | Reducing gas resistance (influence on lifetime due to corrosion) |
|---|---|---|
| Example 1 | A | A |
| Example 2 | B | A |
| Example 3 | A | B |
| Example 4 | A | A |
| Comparative Example 1 | C | C |

As seen from the above results, SiC film susceptors obtained in Examples 1 to 4 did not cause resistance abnormalities or defects in the SiC wafer even when used in an epitaxial growth process, and a high-quality SiC epitaxial wafer was obtained. In addition, no cracks occurred in the susceptor or the SiC film.

### REFERENCE SIGNS LIST

- 1: susceptor
- 2: carbon base material
- 3: thin film (SiC film)
- 4: counterbore portion
- 4a: recess portion
- 5: CVD apparatus
- 10: chamber
- 11: gas inlet
- 12: gas outlet
- 15: heater unit
- 20: support portion
- O: center portion
- L: rotation axis

## Claims

1. A semiconductor heat treatment member comprising:
a base material; and
a SiC film on a surface of the base material, wherein
the SiC film contains a crystal containing 3C-SiC having peaks at (111), (311), (200), (220) and (222) and 2H-SiC having peaks at (101) and (103), and includes, in order from a side of the base material, at least a first SiC layer and a second SiC layer, which have different peak intensities in X-ray diffraction of the crystal.

2. The semiconductor heat treatment member according to claim 1, wherein, in the SiC film, a nitrogen concentration is 0.05 ppm or less, and a boron concentration is 0.02 ppm or less.

3. The semiconductor heat treatment member according to claim 1 or 2, wherein
in the first SiC layer,
a ratio of a peak intensity at the (101) plane of the 2H-SiC to a peak intensity at the (111) plane of the 3C-SiC is 0.000 or more and 0.020 or less, and
a ratio of a peak intensity at the (103) plane of the 2H-SiC to the peak intensity at the (111) plane of the 3C-SiC is 0.000 or more and 0.020 or less.

4. The semiconductor heat treatment member according to any one of claims 1 to 3, wherein
in the second SiC layer,
a ratio of a peak intensity at the (101) plane of the 2H-SiC to a peak intensity at the (111) plane of the 3C-SiC is 0.030 or more and 0.100 or less, and
a ratio of a peak intensity at the (103) plane of the 2H-SiC to the peak intensity at the (111) plane of the 3C-SiC is 0.020 or more and 0.050 or less.
